# EUROPEAN PATENT APPLICATION

(11) **EP 3 647 720 A1**
(43) Date of publication of application: **06.05.2020**
(21) Application number: 18204151.7
(22) Date of filing: 02.11.2018
(51) Int. Cl.: G01C 11/06, G01C 15/00, G05D 1/00, E01C 13/08, A01G 25/00

(54) **SPORTS FIELD PLANNING SYSTEM**

(71) Applicant: Melos GmbH, 49324 Melle (DE)
(72) Inventor: The designation of the inventor has not yet been filed
(74) Representative: Richardt Patentanwälte PartG mbB

(57) **Abstract**

The invention provides for a sports field planning system (100, 900) comprising: a memory (114) for storing machine executable instructions (120) and a processor (108) for controlling the sports field planning system. Execution of the machine executable instructions causes the processor to receive (200) topographic data (122) descriptive of a parcel of land (300). Execution of the machine executable instructions further causes the processor to receive (202) a placement of a sport field (606) defining boundaries (608) on the parcel of land. Execution of the machine executable instructions further causes the processor to calculate (204) surface dimensions (126) of a sports surface for covering the sport field using the topographic data such that the surface dimensions of the sports surface extends at least between the boundaries when the sports surface is placed on the parcel of land.

## Description

### Field of the invention

The invention relates to the planning an construction of sports fields.

### Background and related art

Sports fields or pitches are used for sport activities such as football, American football, rugby, and other sports. Sports fields may have a natural grass surface or may be covered with an artificial turf or hybrid turf.

United States patent application US 2017/0146344A1 discloses topology based adaptive data gathering is disclosed. Payload data gathering by an unmanned aerial vehicle can be adjusted based on topological or topographical characteristics of the area of flight by the unmanned aerial vehicle. The unmanned aerial vehicle collects payload data over an area and may scale up the rate of payload data gathering or slow down the flight as the unmanned aerial vehicle flies over a high or complex structure. Conversely, the unmanned aerial vehicle may advantageously scale down the rate of payload data gathering or speed up the flight as the unmanned aerial vehicle flies over a simple structure or an empty area.

### Summary

The invention provides for a sports field planning system, a computer program and a method of at least partially constructing a sports field in the independent claims. Embodiments are given in the dependent claims.

Because sports fields are constructed on a three dimensional surface, irregularities in the shape of the surface may make it difficult to correctly determine the amount of natural turf, artificial turf, hybrid turf, or sports surface to cover the sports field. For this reason when a sports field is manufactured excess material for covering the sports field is provided. Embodiments may have a means of reducing the excess or wasted covering for the sports field. This may be accomplished by placing the boundaries of the sports field on topographic data. The topographic data provides three-dimensional data which can be accurately used to accurately calculate surface dimensions of the sports field. This knowledge of the surface dimensions enables a more accurate estimate of the amount of covering or sport
more accurately estimate the amount of natural turf, artificial turf, hybrid turf, or sports surface to cover the sports field.

In one aspect the invention provides for a sports field planning system that comprises a memory for storing machine-executable instructions. The sports field planning system further comprises a processor for controlling the sports field planning system. Execution of the machine-executable instructions causes the processor to receive topographic data descriptive of a parcel of land. Topographic data as used herein encompasses data which identifies the parcel of land and the elevation of this parcel of land at various locations. The topographic data may for instance be referenced to geospatial coordinates or they may be referenced to a different local coordinates system.

Execution of the machine-executable instructions further causes the processor to receive a placement of a sports field defining boundaries on the parcel of land. The boundaries on the parcel of land may for instance indicate the boundaries of the sports field or where the sports field may be built. The receiving of the placement may be performed in different ways in different examples. In one example the placement could for example be received by input for a user interface. In another example the placement could be received from a memory or via a network connection. In yet another example the placement may be provided by an automated search algorithm which places the boundaries using an optimization or search algorithm.

Execution of the machine-executable instructions further causes the processor to calculate dimensions of a sports surface placed on the sports field using the topographic data such that the service dimensions of the sports surface extend at least between the boundaries when the sports surface is placed on the parcel of land. A sports surface as used herein encompasses a surface that is suitable for performing athletic activities. Examples of a sport surface include an artificial turf, a hybrid turf, and a polymer mat.

In some instances the boundaries may indicate a minimum size for the sports field. This embodiment may be beneficial because it may be useful for more effectively placing the location of a sports field. For example, often times when sports fields are being built there will be landscaping that is performed. However, the landscaping is often times not accurate enough to construct a sports field which will for example have proper water drainage. Another challenge is that when the sports field is for example constructed using artificial turf the three-dimensional nature of the surface of the sports field may make it difficult to accurately estimate how long rolls of artificial turf should be. This typically results in a large amount of excess artificial turf being produced to ensure that due to the three-dimensional nature of the surface that there is enough artificial turf to cover it all.

In another embodiment the sports field planning system further comprises a drone configured for moving across the parcel of land. The drone comprises a sensor. The sensor is configured for acquiring the topographic data of the parcel of land. The sensor may take a variety of different forms. For example the sensor may be useful in measuring the position of the drone, which may be directly or indirectly useful for measuring the topographic data. There may also be other optical sensors or other types of sensors which are used to measure the topographic data.

In another embodiment the drone is an autonomous wheeled vehicle. This embodiment may be beneficial because it may provide for an inexpensive means of measuring the topographic data. For example, to measure the topographic data it may only be necessary to accurately measure the position of the autonomous wheeled vehicle. As the autonomous wheeled vehicle drives across the parcel of land, it can simply log its position and the topographic data can be derived from this. The use of an autonomous wheeled vehicle may also, in some jurisdictions, be easier because there is no need for a license for a drone.

In another embodiment the drone is configured for flying above the sports field. For example a flying drone such as a quadcopter or other flying drone may be used. This may be beneficial in situations where there is large amounts of over brush or it may be difficult for an autonomous wheeled vehicle. The use of a flying drone may also be beneficial because it may provide for a very quick measurement of the topographic data of the parcel of land.

In another embodiment the sensor comprises a GPS system.

In another embodiment the sensor comprises a GLONASS system.

In another embodiment the sensor comprises a Galileo system.

In another embodiment the sensor comprises a satellite navigation system.

In another embodiment the sensor comprises an optical positioning system. An optical positioning system may take different forms in different examples. For example a stereo camera may be used or the drone may take pictures from various locations and use this to infer or calculate the topographic data. The optical positioning system may also in some cases locate marks or indicators which are then placed on the surface of the parcel of land, which are used for orientating a coordinates system.

In another embodiment the sensor comprises a LIDAR system. This is a laser system which is used for doing direction and range finding measurements, which may be useful in acquiring the topographic data.

In another embodiment the sensor comprises a laser range finder. This may be beneficial because the laser range finder may very accurately measure the distance between the drone and the surface of the parcel of land.

In another embodiment the sensor comprises an inertial guidance system. The use of an inertial guidance system may be beneficial because it may for example help increase the accuracy with which the drone's position is known. For example, when a GPS or other satellite navigation system is used there may be some inaccuracies or uncertainties into the exact position of the drone. With the inertial guidance system the position of the drone may be orders of magnitude better known.

In another embodiment the sensor comprises an indoor navigation system. This may be beneficial when a satellite navigation system cannot be used. It may also be useful when reference optical markers are not placed on the parcel of land.

In another embodiment the sensor comprises a radio location system. The use of a radio location system may be useful for providing information on the position of the drone.

In another embodiment the sensor comprises a stereo camera system. The stereo camera system may be effective in very quickly measuring the position of not only topographic data on the parcel of land but also locating and finding a distance of two objects which are placed or fixed to the parcel of land.

In another embodiment the sensor comprises a camera system. The camera system may for example be useful in range finding and also in identifying objects on the surface of the parcel of land.

In another embodiment execution of the machine-executable instructions further cause the processor to control the drone to acquire the topographic data using the sensor. This may be beneficial because the acquiring of the topographic data and then the calculation of the surface dimensions may for example be automated.

In another embodiment the drone comprises an imaging system. The drone is configured for identifying objects in the parcel of land using the imaging system. The drone system is further configured for marking objects in the topographic data. For example, a standard camera or imaging system may be used to acquire images. The drone may then identify the objects using for example a neural network that has been trained for image recognition. The drone can then use its geospatial information or topographic data to determine the position of this object. This may also facilitate the planning of the sports field.

In another embodiment the sports field planning system is further configured for rendering a placement of the boundaries of the sports field on a rendering of the topographic data. For example this rendering could be performed on a screen or a display. This for example could be a two-dimensional model, a rendering of a three-dimensional rendering, and also renderings of cross-sections of the sports field may also be provided. This embodiment may be beneficial because it may provide for a graphical means to assist someone in the planning of a sports field.

In another embodiment the rendering of the placement of the boundaries of the sports field comprises water drainage indicators. This may for example be useful for a person planning the sports field because it may help them to better visualize how water will drain off of the sports field.

In another embodiment the rendering comprises markings to indicate regions with pooled water. This for example may indicate low portions or pools which may form on the sports field during rain or other precipitation.

In another embodiment the sports field planning system comprises a graphical user interface configured for modifying the placement of boundaries of the sports field on the rendering of the topographic data. This for example may be useful in providing a tool that the operator can use to interactively play on the sports field. This may for example help in placing the sports field around obstacles or known objects as well as properly planning the drainage of the sports field.

In another embodiment execution of the machine-executable instructions further cause the processor to search for an initial placement of the boundaries of the sports field on the rendering of the topographic data using a set of constraints. The set of constraints comprises any one of the following: an optimization of water drainage to the sports field, a desired topographical shape of the sports field, and combinations thereof. This may be beneficial because a search routine or optimization algorithm may be used to initially place the position of the sports field boundaries. This may facilitate the planning of the sports field.

In another embodiment execution of the machine-executable instructions further cause the processor to receive a selection of a turf type. The turf type may for example be an indication of a natural turf or it may be a particular type or manufacture of artificial turf. The turf type may be a selection of the type of sports surface.

Execution of the machine-executable instructions further causes the processor to retrieve turf data from a turf database using the turf type. For example, the turf data may be descriptive of the turf specified by the turf type. Execution of the machine-executable instructions further causes the processor to construct a turf model using the turf data. In this embodiment, once a turf type has been selected, a model is then automatically constructed using the turf data. The turf model may take different forms in different examples. The turf model may for example have details on how the sports field will be constructed using the turf model. The turf model may also be used as a planning means for determining what materials are needed to build the sports field.

In another embodiment execution of the machine-executable instructions further cause the processor to receive a selection of a turf drainage system type. For example this may specify structures or tubes or materials which go underneath the turf which is placed. This may have an effect on the type of drainage of the sports field. Execution of the machine-executable instructions further causes the processor to retrieve drainage system data from the turf database using the turf drainage system type. The drainage system data may therefore be considered to be data which is descriptive of the particular turf drainage system type. It may for example specify how it is constructed and built as well as hydrological properties which may be used in modeling the drainage of the sports field. Execution of the machine-executable instructions further causes the processor to modify the turf model using the turf drainage system data.

In another embodiment execution of the machine-executable instructions further cause the processor to construct a hydrological model of the sports field using the turf model. This for example may be used to update the water drainage and pooling. This may help or assist in the planning of a more effective sports field.

In another embodiment the turf type is an artificial turf.

In another embodiment the turf type is a natural turf.

In another embodiment the turf type is a hybrid turf.

In another embodiment the turf model is constructed using placement of rolls of the artificial turf or hybrid turf. For example, because the parcel of land has a three-dimensional surface it may be difficult to estimate the length of the rolls of artificial turf. For this reason, when sports fields are manufactured using artificial turf, extra lengths are left on the ends of the rolls to ensure that the artificial turf is not too short. The use of the sports field planning system may make it able to make these rolls of artificial turf shorter, thereby saving the wasted artificial turf.

In another embodiment execution of the machine-executable instructions further causes the processor to place the rolls of the artificial turf using constraints. The constraints comprise any one of the following: a turf grain direction of the rolls of the artificial turf relative to adjacent rolls of artificial turf, an orientation of the rolls of the artificial turf relative to the boundaries, and combinations thereof.

In another embodiment the turf model specifies individual roll lengths for the rolls of the artificial turf. This embodiment may be beneficial because it may be used to provide detailed information on how long the rolls of the artificial turf should be. This may help reduce waste of artificial turf.

In another embodiment the individual roll lengths are calculated by first determining a roll location of the individual roll on the topographic data. The individual roll lengths are then further calculated by determining the individual roll length by covering the entire roll location with a flexible two-dimensional surface which has a width of the individual roll and the individual roll length. This embodiment may be beneficial because it may help reduce the amount of wasted artificial turf.

In another embodiment execution of the machine-executable instructions further causes the processor to construct an artificial turf bill of materials using the individual roll lengths. This may be beneficial because the bill of materials may be used to construct the sports field in a cost effective and waste-reducing manner.

In another embodiment execution of the machine-executable instructions further causes the processor to electronically transmit the bill of materials to a computer system controlling the artificial turf factory. This may be beneficial because it may provide for a means of automating the cost effective and efficient manufacture of a sports field.

In another embodiment execution of the machine-executable instructions further causes the processor to construct a three-dimensional sports field model using the topographic data and the turf model. This for example may be beneficial because a three-dimensional sports field model may be used by an architect or planner to demonstrate what the sports field will look like after the sports field has been constructed. So the sports field planning system can be used not only for planning materials for building the sports field, but also could be used for visualizing the sports field before it is actually built.

In another aspect the invention provides for a computer program comprising machine-executable instructions for execution by a processor controlling the sports field planning system. Execution of the machine-executable instructions causes the processor to receive topographic data descriptive of a parcel of land. Execution of the machine-executable instructions further causes the processor to receive a placement of a sports field defining boundaries on the parcel of land. Execution of the machine-executable instructions further causes the processor to calculate surface dimensions of a sports surface placed on the sports field using the topographic data such that the surface dimensions of the sports surface extends between the boundaries.

In another aspect the invention provides for a method of at least partially constructing a sports field. The method comprises receiving topographic data descriptive of a parcel of land. The method further comprises receiving a placement of a sports field defining boundaries on the parcel of land. The method further comprises calculating the surface dimensions of a sports surface placed on the sports field using the topographic data such that the surface dimensions of the sports field extend at least between the boundaries.

In another embodiment the method further comprises controlling a drone to acquire the topographic data using a sensor.

In another embodiment the method further comprises landscaping the parcel of land before receiving the topographic data.

In another embodiment the method further comprises selecting a turf type. The turf type is an artificial turf. The method further comprises constructing a turf model using the turf data descriptive of the turf type. The turf model is constructed by placing rolls of the artificial turf on the topographic data.

In another embodiment the method further comprises selecting a turf drainage system. The method further comprises modifying the turf model using the turf drainage system data which is descriptive of the turf drainage system.

In another embodiment the model specifies individual roll lengths for the rolls of artificial turf.

In another embodiment the individual roll lengths are calculated by determining a roll location of the individual rolls on the topographic data. The individual roll lengths are further calculated by determining an individual roll length by covering the entire roll location with a flexible two-dimensional surface which has a width of the individual roll and the individual roll length.

In another embodiment the method further comprises manufacturing rolls of the artificial turf using the individual roll lengths. The method further comprises delivering the rolls of the artificial turf to the parcel of land. The method further comprises constructing the sports field by installing the artificial turf on the parcel of land using the boundaries.

Various embodiments may possibly be described by one or more of the following features specified in the following numbered clauses:
1. A feature comprising a sports field planning system comprising:
   - a memory for storing machine executable instructions;
   - a processor for controlling the sports field planning system, wherein execution of the machine executable instructions causes the processor to:
      - receive topographic data descriptive of a parcel of land;
      - receive a placement of a sport field defining boundaries on the parcel of land; and
      - calculate surface dimensions of a sports surface for covering the sport field using the topographic data such that the surface dimensions of the sports surface extends at least between the boundaries when the sports surface is placed on the parcel of land.
2. The sports field planning system of clause 1, wherein the sports field planning system further comprises a drone configured for moving across the parcel of land, wherein the drone comprises a sensor, wherein the sensor is configured for acquiring the topographic data of the parcel of land.
3. The sports field planning system of clause 2, wherein the drone is an autonomous wheeled vehicle.
4. The sports field planning system of clause 2, wherein the drone is configured for flying above the sports field.
5. The sports field planning system of clause 3 or 4, wherein the sensor comprises any one of the following: a GPS system, a GLONASS system, a Galileo system, a satellite navigation system, an optical positioning system, a LIDAR system, a laser range finder, an inertial guidance system, an indoor navigation system, a radio location system, a stereo camera system, a camera system, and combinations thereof.
6. The sports field planning system of any one of clauses 2 through 5, wherein execution of the machine executable instructions further cause the processor to control the drone to acquire the topographic data using the sensor.
7. The sports field planning system of any one of clauses 2 through 6, wherein the drone comprises an imaging system, wherein the done is configured for identifying objects in the parcel of land using the imaging system, wherein the drone system is further configured for marking the objects in the topographic data.
8. The sports field planning system of any one of the preceding clauses, wherein the sports field planning system is further configured for rendering of a placement of the boundaries of the sports field on a rendering of the topographic data.
9. The sports field planning system of clause 8, wherein the rendering of the placement of the boundaries of the sports field comprises water drainage indicators.
10. The sports field planning system of any one of clause 8 or 9, wherein the rendering comprises markings to indicate regions with pooled water.
11. The sports field planning system of any one of clauses 8 through 10, wherein the sports field planning system comprises a graphical user interface configured for modifying the placement of the boundaries of the sports field on the rendering of the topographic data.
12. The sports field planning system of any one of clauses 8 through 11, wherein execution of the machine executable instructions further causes the processor to search for an initial placement of the boundaries of the sports field on the rendering of the topographic data using a set of constraints, and wherein the set of constraints comprises any one of the following: an optimization of water drainage of the sports field, a desired topological shape of the sports field, and combinations thereof.
13. The sports field planning system of any one of clauses 8 through 12, wherein execution of the machine executable instructions further causes the processor to:
   - receive a selection of a turf type; and
   - retrieving a turf data from a turf database using the turf type; and
   - constructing a turf model using the turf data.
14. The sports field planning system of clause 13, wherein execution of the machine executable instructions further causes the processor to:
   - receive a selection of a turf drainage system type; and
   - retrieving drainage system data from the turf database using the turf drainage system type; and
   - modifying the turf model using the turf drainage system data.
15. The sports field planning system of clause 13 of 14, wherein execution of the machine executable instructions further causes the processor to construct a hydrological model of the sports field using the turf model.
16. The sports field planning system of any one of clauses 13 through 15, wherein the turf type is any one of the following: an artificial turf, natural grass turf, and hybrid turf.
17. The sports field planning system of clause 16, wherein the turf model is constructed using placement of rolls of the artificial turf.
18. The sports field planning system of clause 17, wherein execution of the machine executable instructions further causes the processor to place the rolls of the artificial turf using constraints, wherein the constrains comprise any one of the following: a turf grain direction of the rolls of the artificial turf relative to adjacent rolls of artificial turf, orientation of the rolls of the artificial turf relative to the boundaries, and combinations thereof.
19. The sports field planning system of clause 17 or 18, wherein the turf model specifies individual roll lengths for the rolls of the artificial turf.
20. The sports field planning system of clause 19, wherein the individual roll lengths are calculated by:
   - determining a roll location of the individual roll on the topographic data; and
   - determining the individual roll length by covering the entire roll location with a flexible two dimensional surface which has a width of the individual roll and the individual roll length.
21. The sports field planning system of any one of clauses 19 through 20, wherein execution of the machine executable instructions further causes the processor to construct an artificial turf bill of materials using the individual roll lengths.
22. The sports field planning system of clause 21, wherein execution of the machine executable instructions further cause the processor to electronically transmit the artificial turf bill of materials to a computer system controlling an artificial turf factory.
23. The sports field planning system of any one of clauses 13 through 22, wherein execution of the machine executable instructions further causes the processor to construct a three dimensional sports field model using the topographic data and the turf model.
24. A feature of a computer program comprising machine executable instructions for execution by a processor controlling a sports field planning system, wherein execution of the machine executable instructions cause the processor to:
   - receive topographic data descriptive of a parcel of land;
   - receive a placement of a sport field defining boundaries on the parcel of land; and
   - calculate surface dimensions of a sports surface for covering the sport field using the topographic data such that the surface dimensions of the sports field extends at least between the boundaries when the sports surface is placed on the parcel of land.
25. A feature comprising a method of at least partially constructing a sports field, wherein the method comprises:
   - receiving topographic data descriptive of a parcel of land;
   - receiving a placement of a sport field defining boundaries on the parcel of land; and
   - calculating surface dimensions of a sports surface for covering the sport field using the topographic data such that the surface dimensions of the sports field extends at least between the boundaries when the sports surface is placed on the parcel of land.
26. The method of clause 25, wherein the method further comprises controlling a drone to acquire the topographic data using a sensor.
27. The method of clause 25 or 26, wherein the method further comprises landscaping the parcel of land before receiving the topographic data.
28. The method of any one of clauses 25 to 27, wherein the method further comprises:
   - selecting a turf type, wherein the turf type is an artificial turf; and
   - constructing a turf model using turf data descriptive of the turf type, wherein the turf model is constructed by placing rolls of the artificial turf.
29. The method of clause 28, wherein the method further comprises:
   - selecting a turf drainage system; and
   - modifying the turf model using turf drainage system data descriptive of the turf drainage system.
30. The method of clause 28 or 29, wherein the turf model specifies individual roll lengths for the rolls of the artificial turf.
31. The method of clause 30, wherein the individual roll lengths are calculated by:
   - determining a roll location of the individual roll on the topographic data; and
   - determining the individual roll length by covering the entire roll location with a flexible two dimensional surface which has a width of the individual roll and the individual roll length.
32. The method of clause 31, wherein the method further comprises:
   - manufacturing rolls of the artificial turf using the individual roll lengths;
   - delivering the rolls of the artificial turf to the parcel of land; and
   - constructing the sports field by installing the artificial turf on the parcel of land using the boundaries.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magnetooptical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

### Brief description of the drawings

In the following embodiments of the invention are explained in greater detail, by way of example only, making reference to the drawings in which:
Fig. 1 illustrates an example of a sports field planning system;
Fig. 2 shows a flow chart which illustrates a method of operating the sports field planning system of Fig. 1;
Fig. 3 illustrates an example of a parcel of land;
Fig. 4 illustrates an example of a drone;
Fig. 5 illustrates a further example of a drone;
Fig. 6 illustrates an example of a user interface;
Fig. 7 illustrates a further example of a user interface;
Fig. 8 illustrates a further example of a user interface;
Fig. 9 illustrates a further example of a sports field planning system;

### Detailed Description

Like numbered elements in these figures are either equivalent elements or perform the same function. Elements which have been discussed previously will not necessarily be discussed in later figures if the function is equivalent.

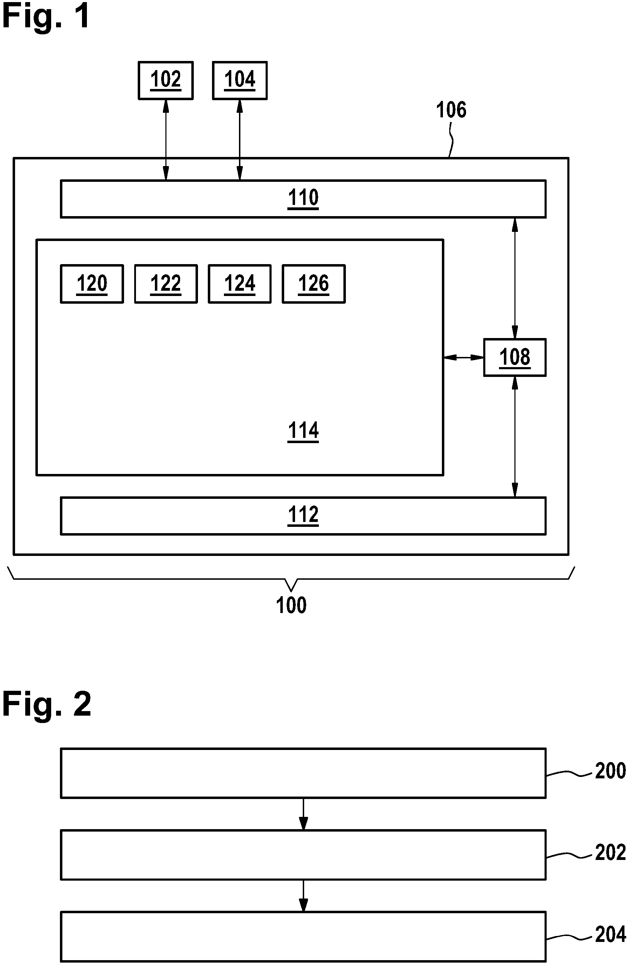

Fig. 1 illustrates an example of a sports field planning system 100. The sports field planning system is shown as optionally comprising a drone 102 and an external server 104. The external server 104 could for example be a database of artificial turf types which are retrieved and used for later modeling. In other examples the optional server 104 may be a server controlling the manufacture or a factory for manufacturing artificial turf.

The sports field planning system 100 comprises a computer 106. The computer 106 comprises a processor 108 that is connected to a hardware 110 or network interface, a user interface 112 and a memory 114. The hardware or network interface 110 enables the processor 108 to communicate with and/or control external components of the sports field planning system 100. The memory 114 is shown as containing machine-executable instructions 120 which enable the processor 108 to perform various calculations and also to control the operation and function of the sports field planning system 100. The memory 114 is further shown as containing topographic data 122 that has been received. The topographic data 122 could for example be received via the user interface 112, from a drone 102, or it may be received from the external server 104. The memory 114 is further shown as containing a placement of a sports field within the topographic data 122. The memory 114 is further shown as containing surface dimensions of a sports field 126. The sports field may be covered with a sports surface such as an artificial turf, hybrid turf, or polymer mat. This is determined by using the placement of the sports field 124 on the topographic data 122 and looking at the dimensions of the two-dimensional sports field on the surface defined by the topographic data 122.

Fig. 2 shows a flowchart which illustrates a method of operating the sports field planning system 100 of Fig. 1. First, in step 200, the processor 108 receives the topographic data 122. Next in step 202 the placement of the sports field 124 is received. The placement of the sports field defines boundaries on the parcel of land, which is described by the topographic data 122. Finally, in step 204, the surface dimensions 126 of a sports surface for covering the sports field are calculated using the topographic data 122 such that the surface dimensions of the sports field extend at least between the boundaries.

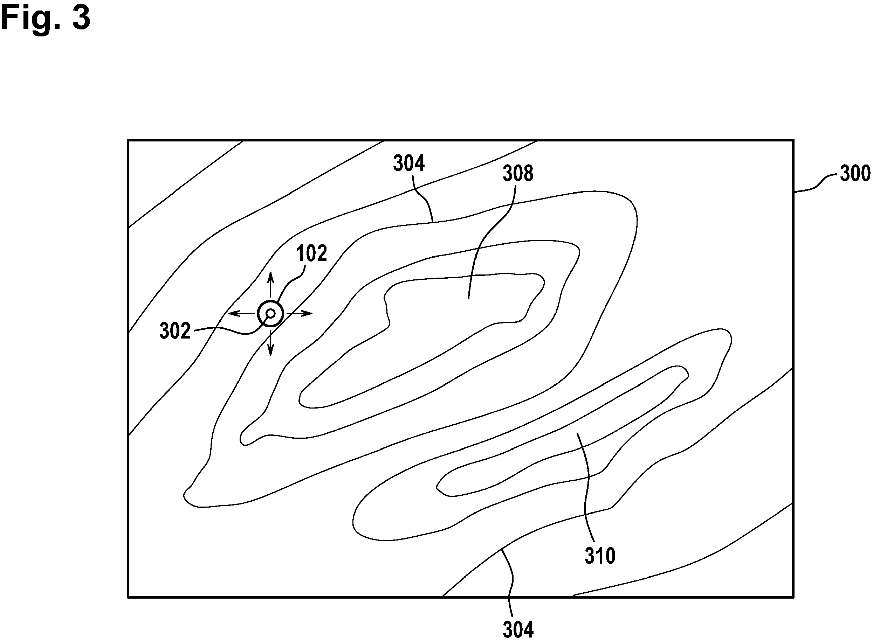

Fig. 3 shows a diagram which represents a parcel of land 300. A drone 102 with a sensor 302 can be seen as being able to move across the surface of the parcel of land 302. The lines labeled 304 are contour lines and are intended to represent different elevations of the parcel of land 300. In this example there is a hill 308 and a sink or depression 310. As the drone 102 moves across the surface of the parcel of land 300, it is able to acquire the topographic data using the sensor 302. The sensor may be any individual sensor or a combination of a variety of sensors which may be used for measuring the position of the drone 102 and/or the topographical elevation of the parcel of land 300. For example, the sensor may include one or more of the following: a GPS system, a GLONASS system, a Galileo system, a satellite navigation system, an optical positioning system, a LIDAR system, a laser range finder, an inertial guidance system, an indoor navigation system, a radio location system, a stereo camera system, and a camera system.

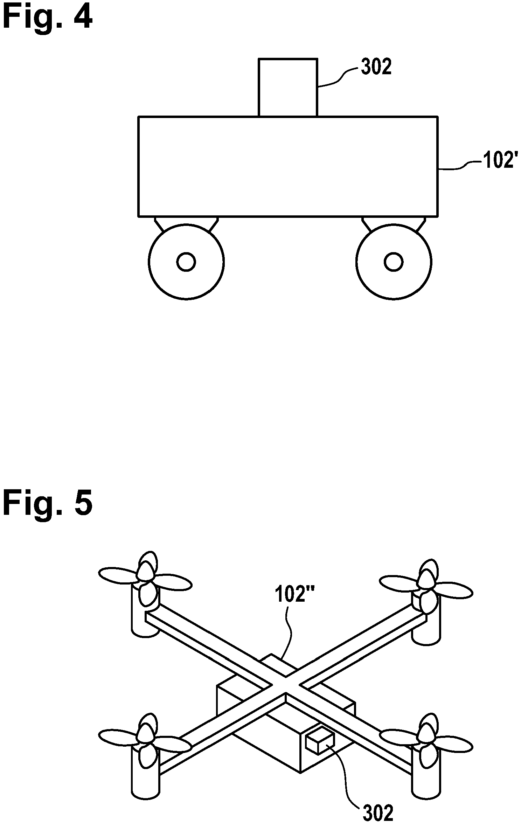

Fig. 4 illustrates one example of a drone. In Fig. 4 the drone is an autonomous wheeled vehicle 102'. The autonomous wheeled vehicle 102' comprises a system for moving and steering the autonomous wheeled vehicle 102 over the surface of the parcel of land 300 to measure the topographic data. The autonomous wheeled vehicle 102' may comprise any one of the sensors 302 as previously described.

Fig. 5 illustrates a further example of a drone. In this example the drone is an aerial drone 102". A small airplane or quadcopter are two such examples of an aerial drone 102". The aerial drone 102" may also comprise one or more of the sensors 302 which are previously described.

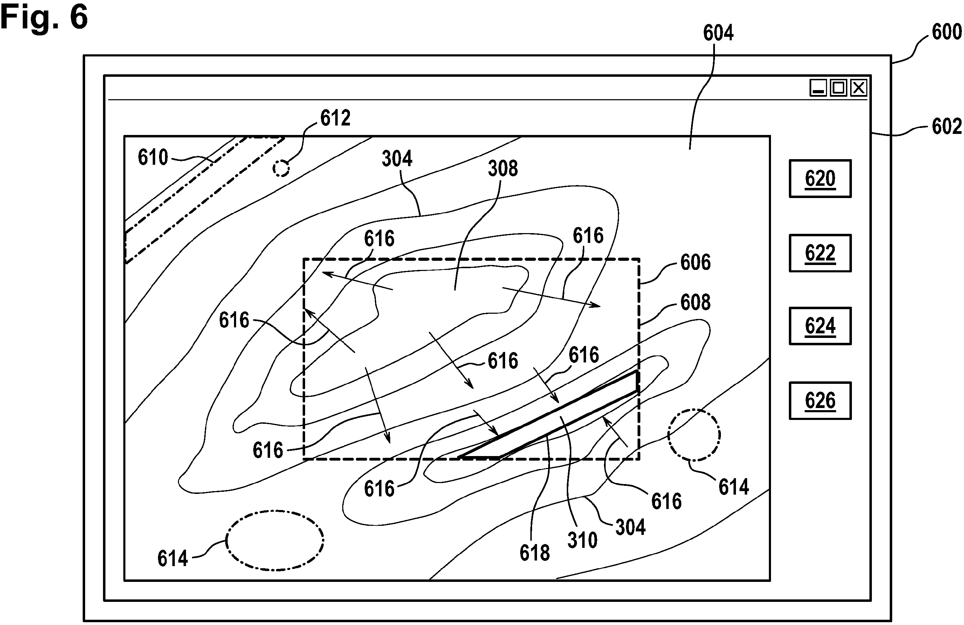

Fig. 6 illustrates an example of a display 600 of a graphical user interface 602. On the graphical user interface 602 is a rendering 604 of the topographic data. Superimposed on the rendering 604 is a placement of the sports field 606. The dashed line labeled 608 represents the boundary of the sports field 606. Also on the rendering 604 is an indication of the location of a walkway 610, a lamppost 612 and several trees 614. These for example may have been identified by an optical sensor or camera of the drone 102. Within the location of the field 606 are also a number of arrows 616 which are water drainage indicators. They indicate the direction where water will flow. The dark line 618 indicates a region which is a warning that there may be pooled water after rainfall on the field 606. The area indicated where there may be pooled water 618 corresponds to the area where the sink 310 is.

The graphical user interface 602 may also have a number of additional controls. For example, button 620 may be used to control the import or acquisition of topographic data. Button 622 may cause the boundaries 608 of the sports field 606 to be placed automatically using a search algorithm. Button 624 may be used to construct a model of the field 606, for example by selecting a particular type of artificial turf to use. Button 626 may cause the artificial turf needed to construct the field 606 to be ordered. This may include sending data descriptive of rolls and lengths of artificial turf to be ordered directly to a factory.

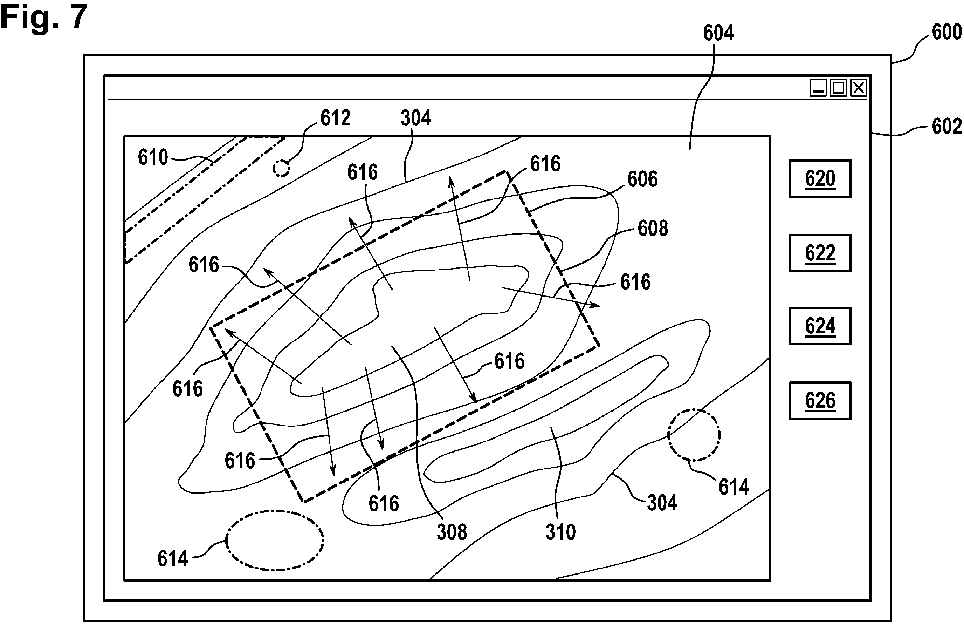

Fig. 7 shows a further view of the display 600 and graphical user interface 602 of Fig. 6. In this example the position and boundaries 608 of the field have been moved either manually or by placing the auto placement button 622. It can be seen now that the field 606 is placed such that the water drainage indicators 616 indicate that water will preferentially drain from the center of the sports field 606. The obstacles 610, 612, 614 have been avoided as well as placing the field 606 over the sink 310.

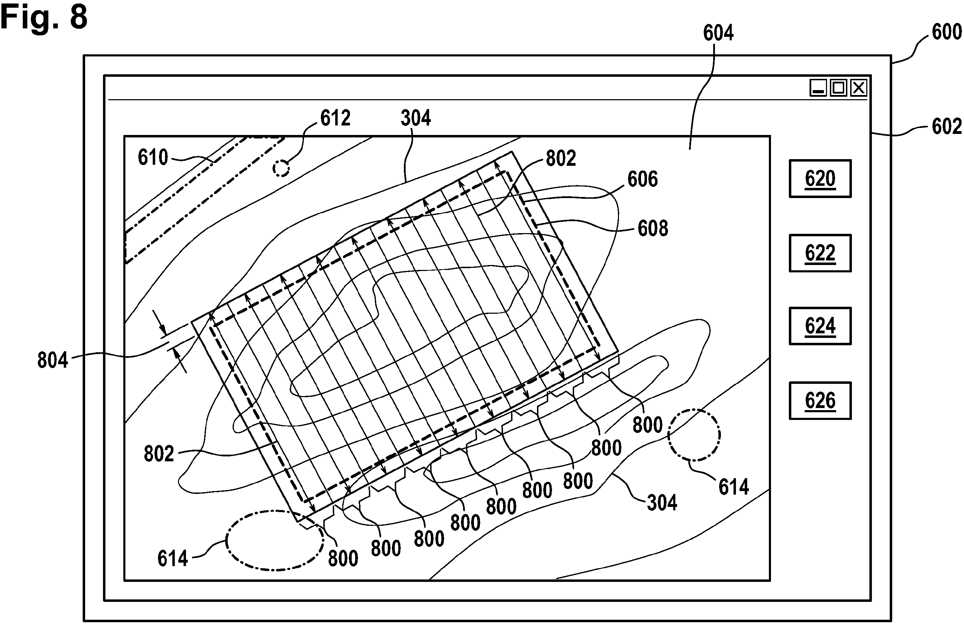

Fig. 8 shows the graphical user interface of Figs. 7 and 6 after the construct model button 624 has been pressed. After the button was pressed the user selected a type of artificial turf and then the placement of rolls of artificial turf was automatically placed to cover the boundaries 608 of the sports field 600. The label 800 indicates the position of each roll of artificial turf. Each roll also has an arrow, some of which are labeled 802. This is the individual length of each roll. As the artificial turf 800 is sitting on a three-dimensional surface the length of the different sections of artificial turf 800 will be different. It should be noted that in this Fig. the artificial turf 800 is shown as extending beyond the boundaries 608 of the sports field 606. There is an overhang 804. This is to ensure that the artificial turf is long enough to completely cover the sports field 606. Normally it is extremely difficult to properly estimate the lengths 802. Using this model however, the overhang 804 can be reduced reducing the amount of artificial turf needed to manufacture the sports field 606. There may also be tools within the graphical user interface 602 that enable the operator to adjust the size of the overhang 804 or to switch between various types of artificial turf. When the design is finished the operator may hit button 626 and automatically construct an order which may, in some instances, be sent automatically to a server 104 which causes the artificial turf to be manufactured.

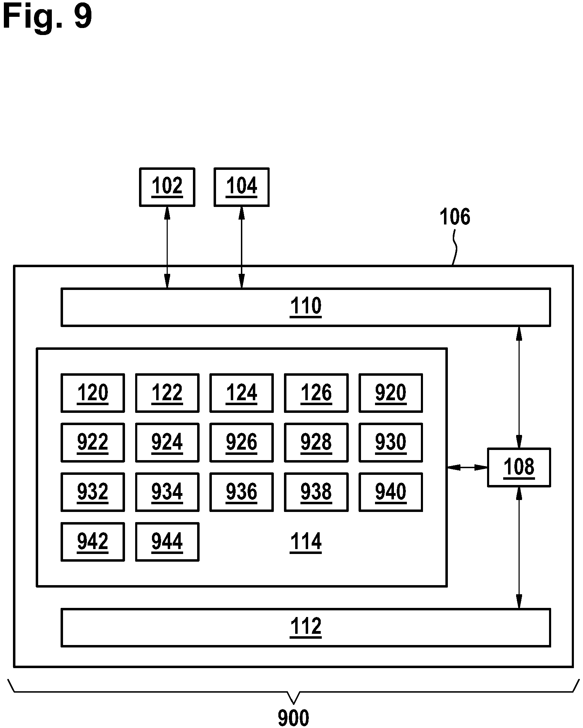

Fig. 9 illustrates a further example of a sports field planning system. The sports field planning system 900 contains the features of the sports field planning system of Fig. 1 with a number of additional entries in its memory 114. The memory 114 is further shown as containing a field placement algorithm 920 that is able to use constraints 922 and either a search or optimization algorithm that determines a position or initial placement of the sports field 606. The field placement constraints 922 are shown as being stored in the memory 114 also. The field placement constraints 922 may be used to avoid such things as placing the field over obstacles such as trees or lights and also to maintain proper drainage. The memory 114 is further shown as containing a turf type selection 924. The turf type selection 924 could for example be the selection of a particular type or model of artificial turf. The turf type selection 924 was then used by the processor 108 to retrieve turf type data 926 which is descriptive of the turf type that was selected. This for example could be stored in a local database or it could for example be retrieved from the remote server 104. The memory 114 is further shown as containing a turf model 928 that was constructed using the turf type data 926. This for example may provide instructions which enables the processor 108 to automatically design and place artificial components for manufacturing the turf.

The memory 114 is further shown as containing the turf model 928 that was constructed using the turf type data 926. The turf model for example may be an example of the placements of the artificial turf 800 as is illustrated in Fig. 8.

The memory 114 is further shown as containing a turf drainage system type selection 930. This is a selection of a particular drainage system which may be installed underneath the artificial turf. The memory 114 is further shown as containing drainage system data 932 which contains data necessary for the processor 108 to automatically design and construct a turf drainage system of the type specified by 930. This again may be retrieved from a local database or may be retrieved from the remote server 104. The drainage system data 932 is shown as being stored in the memory 114 as well as a modified turf model 934. This may be the turf model 928 that has been modified using the drainage system data 932. The memory 114 is further shown as containing a hydrological model 936 that contains data that can be used for modeling the drainage of the field 606. This for example may be constructed using the modified turf model 934 or the turf model 928.

The memory 114 shows some additional details of the turf model 928 or the modified turf model 934. In this case this is the location of artificial turf roll placements 938. These correspond to the location of the rolls of artificial turf 800 as shown in Fig. 8. The memory 114 is shown as containing individual roll lengths 940 which correspond to the lengths 802 shown in Fig. 8. The memory 114 is further shown as containing a bill of materials. This for example may include rolls of artificial turf using the individual roll lengths 940 to construct the order. The bill of materials 942 may for example be automatically transmitted to the remote server 104 so that the artificial turf is automatically manufactured. The memory 114 is further shown as containing a three-dimensional sports field model 944. The three-dimensional sports field model 944 may for example be rendered using a computer aid design or other three-dimensional modeling software so that the designer of the field 606 can show the design to clients or the potential sports clubs who will have the sports field built.

### List of reference numerals

- 100: sports field planning system
- 102: drone
- 102': autonomous wheeled vehicle
- 102": aerial drone
- 104: external server
- 106: computer
- 108: processor
- 110: hardware / network interface
- 112: user interface
- 114: memory
- 120: machine executable instructions
- 122: topographic data
- 124: placement of sports field
- 126: surface dimensions of a sports surface
- 200: receive topographic data descriptive of a parcel of land
- 202: receive a placement of a sport field defining boundaries on the parcel of land
- 204: calculate surface dimensions of a sports surface using the topographic data such that the sports surface extends between the boundaries
- 300: parcel of land
- 302: sensor
- 304: contour lines
- 308: hill
- 310: sink
- 600: display
- 602: graphical user interface
- 604: rendering of topographical data
- 606: placement of sports field
- 608: boundary of sports field
- 610: location of walkway
- 612: location of lamp post
- 614: location of tree
- 616: water drainage indicators
- 618: pooled water warning indicator
- 620: import/acquire topographic data
- 622: auto place sports field
- 624: construct model of field
- 626: order artificial turf
- 800: position of roll of artificial turf
- 802: length of roll of artificial turf
- 804: overhang of artificial turf
- 900: sports field planning system
- 920: field placement algorithm
- 922: field placement constraints
- 924: turf type selection
- 926: turf type data
- 928: turf model
- 930: turf drainage system type
- 932: drainage system data
- 934: modified turf model
- 936: hydrological model
- 938: artificial turf roll placements
- 940: individual roll lengths
- 942: bill of materials
- 944: three dimensional sports field model

## Claims

1. A sports field planning system (100, 900) comprising:
- a memory (114) for storing machine executable instructions (120);
- a processor (108) for controlling the sports field planning system, wherein execution of the machine executable instructions causes the processor to:
- receive (200) topographic data (122) descriptive of a parcel of land (300);
- receive (202) a placement of a sport field (606) defining boundaries (608) on the parcel of land; and
- calculate (204) surface dimensions (126) of a sports surface for covering the sport field using the topographic data such that the surface dimensions of the sports surface extends at least between the boundaries when the sports surface is placed on the parcel of land.

2. The sports field planning system of claim 1, wherein the sports field planning system further comprises a drone (102, 102', 102") configured for moving across the parcel of land, wherein the drone comprises a sensor (302), wherein the sensor is configured for acquiring the topographic data of the parcel of land.

3. The sports field planning system of claim 2, wherein the drone is any one of the following:
- an autonomous wheeled vehicle (102') and
- configured for flying above the sports field.

4. The sports field planning system of claim 3 , wherein the sensor comprises any one of the following: a GPS system, a GLONASS system, a Galileo system, a satellite navigation system, an optical positioning system, a LIDAR system, a laser range finder, an inertial guidance system, an indoor navigation system, a radio location system, a stereo camera system, a camera system, and combinations thereof.

5. The sports field planning system of any one of claims 2 through 4, wherein execution of the machine executable instructions further cause the processor to control the drone to acquire the topographic data using the sensor.

6. The sports field planning system of any one of claims 2 through 5, wherein the drone comprises an imaging system, wherein the done is configured for identifying objects (610, 612, 614) in the parcel of land using the imaging system, wherein the drone system is further configured for marking the objects in the topographic data.

7. The sports field planning system of any one of the preceding claims, wherein the sports field planning system is further configured for rendering of a placement (606) of the boundaries (608) of the sports field on a rendering of the topographic data.

8. The sports field planning system of claim 7, wherein the rendering of the placement of the boundaries of the sports field comprises water drainage indicators (616), and wherein the rendering comprises markings (310) to indicate regions with pooled water.

9. The sports field planning system of any one of claims 7 through 8, wherein execution of the machine executable instructions further causes the processor to:
- receive a selection of a turf type (924);
- retrieving a turf data (926) from a turf database using the turf type;
- constructing a turf model (928) using the turf data, wherein the turf model is constructed using placement of rolls of the artificial turf;
- receive a selection of a turf drainage system type (930);
- retrieving drainage system data (932) from the turf database using the turf drainage system type; and
- modifying the turf model using the turf drainage system data.

10. The sports field planning system of claim 9,
wherein the turf type is an artificial turf or a hybrid turf, wherein the turf model is constructed using placement of rolls of turf, wherein execution of the machine executable instructions further causes the processor to place the rolls of the turf using constraints, wherein the constrains comprise any one of the following: a turf grain direction of the rolls of the turf relative to adjacent rolls of the turf, orientation of the rolls of the turf relative to the boundaries, and combinations thereof, wherein the turf model specifies individual roll lengths for the rolls of the turf.

11. The sports field planning system of claim 10, wherein execution of the machine executable instructions further causes the processor to:
- construct an artificial turf bill of materials (942) using the individual roll lengths; and
- electronically transmit the artificial turf bill of materials to a computer system controlling an artificial turf factory.

12. A computer program comprising machine executable instructions (120) for execution by a processor (108) controlling a sports field planning system (100, 900), wherein execution of the machine executable instructions cause the processor to:
- receive (200) topographic data (122) descriptive of a parcel of land (300);
- receive (202) a placement of a sport field (606) defining boundaries (608) on the parcel of land; and
- calculate (204) surface dimensions of a sports surface for covering the sport field using the topographic data such that the surface dimensions of the sports field extends at least between the boundaries when the sports surface is placed on the parcel of land.

13. A method of at least partially constructing a sports field, wherein the method comprises:
- receiving (200) topographic data (122) descriptive of a parcel of land (300);
- receiving (202) a placement of a sport field (606) defining boundaries (608) on the parcel of land; and
- calculating (204) surface dimensions of a sports surface for covering the sport field using the topographic data such that the surface dimensions of the sports field extends at least between the boundaries when the sports surface is placed on the parcel of land.

14. The method of claim 13, wherein the method further comprises controlling a drone (102, 102', 102") to acquire the topographic data using a sensor (302).

15. The method of any one of claim 13 or 14, wherein the method further comprises:
- selecting a turf type (924), wherein the turf type is an artificial turf;
- constructing a turf model (928) using turf data descriptive of the turf type, wherein the turf model is constructed by placing rolls of the artificial turf, wherein the turf model specifies individual roll lengths for the rolls of the artificial turf;
- selecting a turf drainage system (930); and
- modifying the turf model using turf drainage system data descriptive (932) of the turf drainage system.
